# DEMANDE DE BREVET EUROPEEN

(11) **EP 2 685 497 A1**
(43) Date de publication de la demande: **15.01.2014**
(21) Numéro de dépôt: 13175433.5
(22) Date de dépôt: 05.07.2013
(51) Int. Cl.: H01L 27/02, H01L 27/12, H01L 29/786

(54) **Circuit integre sur soi comprenant une diode laterale de protection contres des decharges electrostatiques**

(30) Priorité: 13.07.2012 FR 1256800
(71) Demandeur: Commissariat à l'Énergie Atomique et aux Énergies Alternatives, 75015 Paris (FR); STmicroelectronics SA, 92120 Montrouge (FR)
(72) Inventeur: Fenouillet-Beranger, Claire, 38000 GRENOBLE (FR); Fonteneau, Pascal, 38570 THEYS (FR)
(74) Mandataire: Guérin, Jean-Philippe

(57) **Abrégé**

L'invention concerne un circuit intégré comprenant :
-un premier composant (4) comportant une diode p-n (20), ménagée sur un côté du premier transistor et comportant des première (22) et seconde (24) zones semi-conductrices de dopages opposés.

Selon l'invention :
-ces première et seconde zones semi-conductrices sont étant coplanaires à un premier plan de masse,
-le premier composant comprend en outre :
• une seconde tranchée d'isolation (26) pour séparer ces première et seconde zones semi-conductrices, cette seconde tranchée d'isolation s'étendant au travers d'une couche isolante enterrée, jusque dans le premier plan de masse et jusqu'à une profondeur strictement inférieure à l'interface entre le premier plan de masse et un premier caisson, et
• une troisième zone (28) semi-conductrice sous la seconde tranchée, formant une première jonction entre les première et seconde zones.

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (« latchup » en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil (« threshold voltage » en langue anglaise, et abrévié V_{T}) de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal. Cependant, en technologie FDSOI (pour « Fully Depleted Silicium On Insulator » en langue anglaise, désignant du silicium totalement déserté sur isolant), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse polarisé disposé entre une couche d'oxyde isolante mince et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT (pour « Low V_{T} » en langue anglaise, typiquement 400mV), de transistors à haute tension de seuil dits HVT (pour « High V_{T} » en langue anglaise, typiquement 550mV) et de transistors à tension de seuil moyenne dits SVT (pour « Standard V_{T} » en langue anglaise, typiquement 450mV) ou RVT (pour « Regular V_{T} » en langue anglaise).

Pour permettre le fonctionnement des différents transistors, il est nécessaire de les isoler électriquement les uns des autres. Par conséquent, les transistors sont généralement entourés par des tranchées d'isolation (désignées par l'acronyme STI pour « Shallow Trench Isolation » en langue anglaise) qui s'étendent jusqu'en dessous des caissons.

De façon connue, de tels circuits intégrés incluent également des dispositifs de protection contre des décharges électrostatiques (ESD, pour « Electrostatic Discharge » en langue anglaise) accidentelles et pouvant détériorer ces transistors.

Le document US2007/063284 décrit un circuit intégré comprenant un transistor FDSOI ménagé sur une couche isolante de type UTBOX. Un plan de masse semi-conducteur est disposé sous la couche isolante enterrée. Un caisson est disposé sous ce plan de masse. Une tranchée d'isolation est ménagée à la périphérie du transistor au travers de la couche isolante et s'étend jusque dans le caisson. Une autre tranchée d'isolation s'étend au travers de la couche isolante, sans atteindre le caisson. Une diode est ménagée sur le côté du transistor à partir de deux zones semi-conductrices de dopages opposés et en contact l'une avec l'autre pour former une diode.

Un autre exemple d'un tel dispositif de protection est celui décrit par Akram A. Salman et al. dans l'article intitulé « ESD Protection for SOI Technology using Under-the-BOX (substrate) Diode Structure » et publié dans la revue « IEEE Transactions on Device and Materials Reliability », vol. 6, n° 2, juin 2006. Dans cet exemple, le dispositif comprend une diode p-n, ménagée sur un côté du transistor et sous la couche isolante. Cette diode p-n comprend des première et seconde zones semi-conductrices, de dopages opposés, entre lesquelles s'étend une troisième zone semi-conductrice de niveau de dopage inferieur. Les première et seconde zones présentent des contacts électriques respectifs, séparés l'un de l'autre par une tranchée d'isolation s'étendant sur le dessus de la couche isolante.

Ce dispositif présente néanmoins certains inconvénients. D'une part, les performances électriques de la diode sont dégradées par la présence de courants de fuite importants entre les première et seconde zones semi-conductrices, ce qui peut affecter les performances de la diode. D'autre part, les procédés de fabrication typiquement employés n'offrent qu'un contrôle réduit de la largeur de la diode, ce qui a pour inconvénients d'une part de limiter le nombre de telles diodes pouvant être réalisées sur une surface donnée du circuit, et d'autre part de restreindre un contrôle de propriétés électriques de ladite diode, comme par exemple la tension de claquage ou la fuite. Enfin, la tranchée d'isolation est susceptible d'être endommagée lors d'étapes de fabrication du circuit intégré. En effet, les procédés de fabrication comprennent des étapes de formation et de retrait de masques isolants qui sont susceptibles de dégrader structurellement des bords latéraux de ladite tranchée.

L'invention vise à résoudre un ou plusieurs de ces inconvénients. L'invention porte ainsi sur un circuit intégré tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 illustre un circuit intégré ;
- la figure 2 illustre une vue d'un composant du circuit de la figure 1 selon le plan de coupe A-A' ;
- les figures 3 et 5 illustrent des modes de réalisation du composant de la figure 2, vus selon le plan de coupe B-B' de la figure 1 ;
- les figures 4 et 6 illustrent des modes de réalisation du composant de la figure 2, vus selon le plan de coupe C-C' de la figure 1 ;
- la figure 7 illustre une vue du circuit de la figure 1 selon le plan de coupe D-D' ;
- la figure 8 est un schéma électrique correspondant au circuit de la figure 1 selon un premier mode de réalisation ;
- la figure 9 est un schéma électrique correspondant au circuit de la figure 1 selon un second mode de réalisation ;
- la figure 10 illustre un autre mode de réalisation du circuit de la figure 1 ;
- la figure 11 illustre une vue du circuit de la figure 10 selon le plan de coupe E-E' ;
- la figure 12 est un schéma électrique correspondant au circuit de la figure 11 selon un premier mode de réalisation ;
- la figure 13 est un schéma électrique correspondant au circuit de la figure 11 selon un second mode de réalisation ;
- la figure 14 illustre un autre mode de réalisation du circuit de la figure 1 ;
- la figure 15 illustre une vue du circuit de la figure 14 selon le plan de coupe F-F ;
- la figure 16 illustre une vue du circuit de la figure 14 selon le plan de coupe G-G' ;
- la figure 17 est un schéma électrique correspondant au circuit de la figure 16 selon un premier mode de réalisation ;
- la figure 18 est un schéma électrique correspondant au circuit de la figure 16 selon un second mode de réalisation ;
- la figure 19 illustre un autre mode de réalisation du circuit de la figure 1 ;
- la figure 20 est un schéma électrique correspondant au circuit de la figure 19 ;
- la figure 21 illustre un autre mode de réalisation du circuit de la figure 19 ;
- la figure 22 illustre un schéma électrique correspondant au circuit de la figure 21 ;
- la figure 23 illustre un autre mode de réalisation d'une tranchée d'isolation du circuit de la figure 1 ;
- la figure 24 illustre un autre mode de réalisation du composant de la figure 2.

L'invention propose d'utiliser, dans un circuit intégré, des tranchées d'isolation de profondeur et de dimensions réduites afin de réaliser des dispositifs de protection ESD du circuit intégré, ces dispositifs de protection présentant des propriétés structurelles et électriques améliorées.

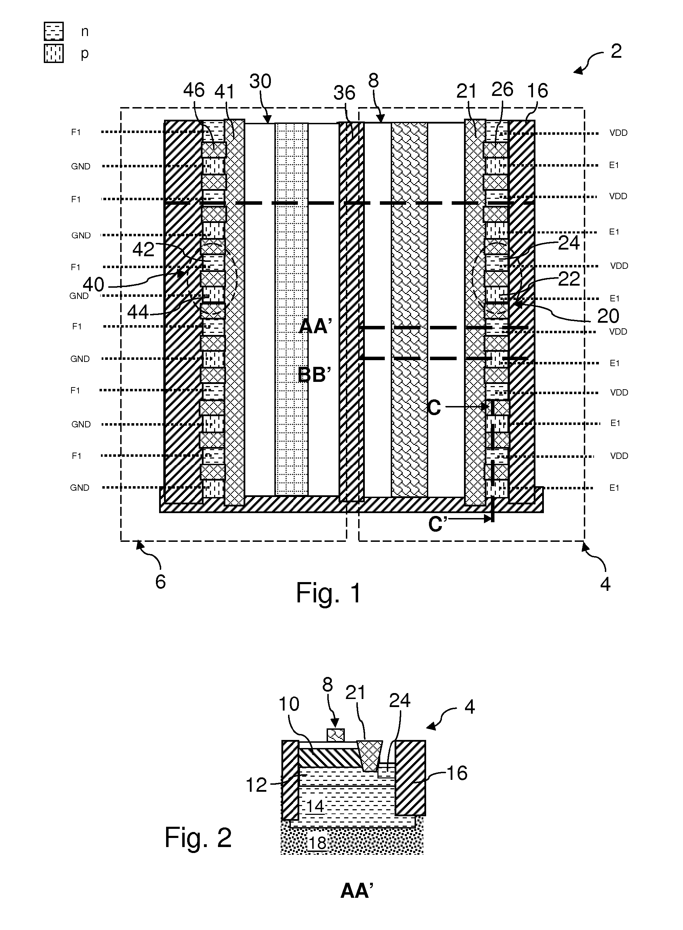

La figure 1 représente un circuit intégré 2 fabriqué sur SOI. Dans cet exemple, ce circuit 2 comporte des composants 4 et 6.
Les figures 2 à 6 décrivent plus en détail le premier composant 4. Ce composant 4 comprend :
   - un transistor 8 métal oxyde semi-conducteur (MOS) à effet de champ, de technologie FDSOI ;
   - une couche isolante enterrée 10 de type UTBOX (« Ultra-Thin Buried Oxide Layer » en langue anglaise), formée à l'aplomb du transistor 8 ;
   - un plan de masse 12 semi-conducteur, formé à l'aplomb de la couche isolante 10 ;
   - un caisson semi-conducteur 14, formé à l'aplomb du plan de masse 12 ;
   - une tranchée d'isolation 16 de type STI ;
   - un substrat semi-conducteur 18, situé sous le caisson 14.

Le transistor 8 comporte une couche d'un matériau semi-conducteur, dite couche active, formée sur la couche isolante 10 et à l'aplomb de cette couche isolante 10. Pour simplifier les dessins, la structure détaillée de cette couche active n'y est pas représentée. Cette couche active peut comporter de façon connue en soi un canal en matériau semi-conducteur faiblement dopé, avec une concentration de dopants sensiblement égale à la concentration de dopants du substrat 18. Le transistor 8 comporte également des électrodes de grille, de source et de drain.

La couche isolante enterrée 10 isole électriquement le transistor 8 du plan de masse 12, du caisson 14 et du substrat 18.

Le plan de masse 12 est configuré pour être polarisé en tension, typiquement par l'intermédiaire d'un circuit de commande non représenté ici. La polarisation du plan de masse 12 permet de contrôler la tension de seuil du transistor 8.

La tranchée 16 est ménagée à la périphérie du transistor 8 et s'étend en profondeur au travers de la couche isolante 10, jusque dans le caisson 14.

Le composant 4 est apte à protéger le transistor 8 contre des décharges électrostatiques pouvant survenir sur une ou plusieurs électrodes du transistor 8. A cet effet, le composant 4 comporte une diode 20 à jonction p-n, ménagée sur un côté du transistor 8 et séparée de ce transistor 8 par une tranchée d'isolation 21. Cette diode 20 comporte des première 22 et seconde 24 zones semi-conductrices, présentant des types de dopage opposés. Ces zones 22 et 24 sont coplanaires au plan de masse 12. Par coplanaire, on entend que l'on peut définir un plan parallèle à la couche 10 et traversant les zones concernées. La zone 22 est électriquement connectée à une première électrode E1 du transistor 8. La zone 24 est électriquement connectée à une seconde électrode E2 du transistor 8.

Le composant 4 comprend en outre une seconde tranchée d'isolation 26, pour séparer entre elles les zones 22 et 24 de la diode 20. Cette tranchée 26 est formée d'un matériau électriquement isolant. Cette tranchée 26 s'étend au travers de la couche isolante 10, jusque dans le plan de masse 12 et jusqu'à une profondeur strictement inférieure à l'interface entre le plan de masse 12 et le caisson 14. Dans cette description, la profondeur sous la couche isolante 10 est définie par rapport à un plan s'étendant le long de l'interface séparant la couche isolante 10 et le plan de masse 12 et le long d'une direction verticale, perpendiculaire à la direction du plan du substrat 18.

Le composant 4 comporte également une troisième zone semi-conductrice 28. Cette zone 28 s'étend sous la tranchée 26 et forme une première jonction semi-conductrice entre les zones 22 et 24. Cette zone 28 permet la circulation de porteurs de charge électrique entre les zones 22 et 24. La diode 20 peut être considérée comme planaire, du fait de la présence des zones semi-conductrices 22, 24 et 28 côte-à-côte dans une même couche du circuit.

La tranchée 26 s'étend au travers de la couche isolante 10 et sous la couche isolante 10, tout en présentant une profondeur sensiblement moindre que celle de la tranchée 16. Cela permet d'atténuer l'apparition de courants de fuite entre les zones 22 et 24 et d'améliorer les performances électriques de la diode 20.

De plus, la dimension latérale d'une telle tranchée 26 peut être réduite. La dimension latérale de la tranchée 26 désigne ici la plus petite distance séparant les zones 22 et 24 l'une de l'autre. Cette réduction de la dimension latérale permet d'une part d'améliorer le contrôle de certaines propriétés électriques de la diode 20, telle que la tension de claquage, et d'autre part de réduire l'espace occupé par le circuit 2. En particulier, si la diode était réalisée avec une tranchée d'isolation ménagée sur la couche isolante 10 sans traverser la couche isolante 10, la dimension latérale de la tranchée d'isolation ne pourrait pas être aussi facilement réduite sans dégrader des performances électriques de la diode.

Par exemple, avec les procédés de fabrication FDSOI typiquement utilisés pour le noeud technologique 20nm, la tranchée 26 peut présenter une dimension latérale inférieure à 70nm.

D'autre part, en limitant la profondeur de la tranchée 26 à une profondeur sensiblement inférieure à celle de la tranchée 16, les performances électriques de la diode 20 peuvent être améliorées, notamment en limitant le temps de transit de porteurs de charge circulant dans la zone 28 entre les zones 22 et 24, et en améliorant ainsi la protection du composant 4 contre les décharges électrostatiques en limitant la valeur maximale de surintensité.

Ici, cette tranchée 26 s'étend jusqu'à une profondeur de 80nm, 70nm, ou 60nm et, de préférence, inférieure ou égale à 50nm en-dessous de l'interface séparant la couche isolante 10 du plan de masse 12. La dimension latérale de cette tranchée 26 est inférieure ou égale à 150nm ou 100nm et, de préférence, inférieure ou égale à 70nm.

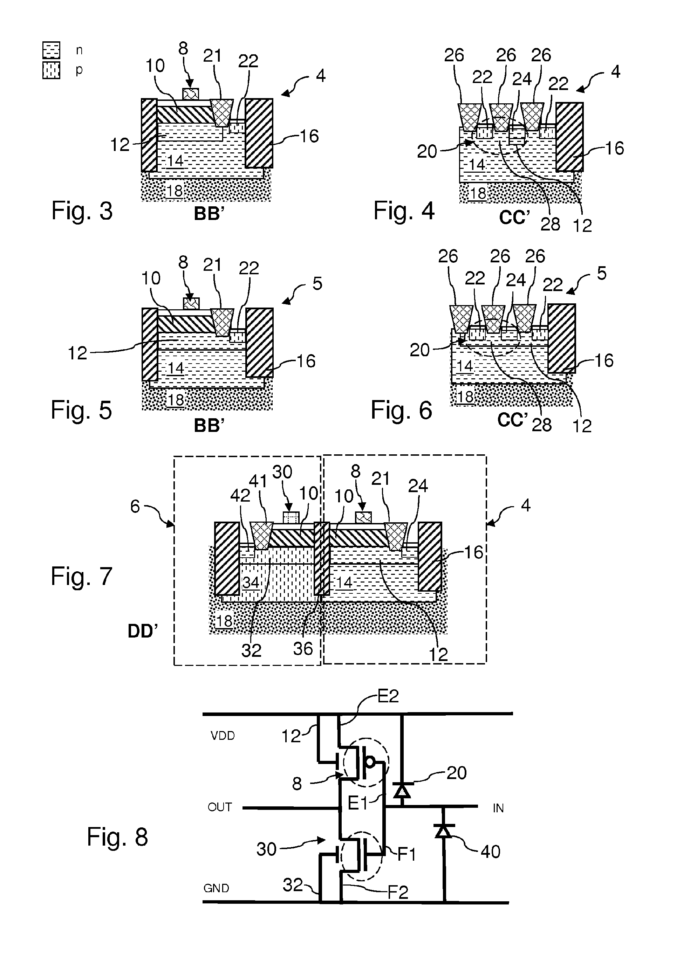

Comme illustré à la figure 4, la zone 28 est ici formée par un prolongement du caisson 14. Ce prolongement s'étend latéralement au-delà de la tranchée 21, puis selon la direction verticale jusqu'à la tranchée 26. La tranchée 21 et la tranchée 26 présentent une même profondeur.

Ici, le composant 4 comporte une pluralité de zones 22 et 24, ménagées le long du transistor 8. Ces zones 22 et 24 forment une pluralité de diodes 20, contiguës les unes aux autres. Deux diodes 20 contiguës présentent une zone 22 ou 24 en commun. Pour simplifier les figures 1, 4 et 6, seule une diode 20 est mise en évidence (entourée par un trait pointillé).

Les figures 5 et 6 illustrent un composant 5 pouvant être utilisé à la place du composant 4. Dans ce composant 5, la zone 28 est formée par prolongement latéral (direction parallèle au plan du substrat 18) du plan de masse 12 au-delà de la tranchée 21. Ainsi, la diode 20 présente une tension de claquage réduite.

Dans ces exemples, le transistor 8 est un transistor FDSOI de type p-MOS. Le transistor 8 présente une longueur de grille de 20nm. La couche isolante 10 présente une épaisseur inférieure ou égale à 60nm, inférieure ou égale à 50nm, voir inférieure ou égale à 20nm. La couche isolante 10 ainsi que les tranchées 16 et 26 sont réalisées en oxyde de silicium dans ces exemples. Le plan de masse 12 et le caisson 14 présentent des dopages de type n, avec les concentrations de dopants comprises:
- entre 10¹⁶cm⁻³ et 10¹⁸cm⁻³ pour le caisson 14 ;
- entre 10¹⁸cm⁻³ et 10¹⁹cm⁻³ pour le plan de masse 12.

Ici, avec ces choix de type de dopage du plan de masse 12 et du caisson 14, le transistor 8 présente une gamme de tensions de seuil de type RVT, c'est-à-dire qu'il présente une tension de seuil de valeur intermédiaire, typiquement comprise entre 0,35V et 0,45V. Ici, le substrat 18 est réalisé en silicium avec un dopage de type p, et présente une concentration de dopants inférieure ou égale à 10¹⁶cm⁻³ et, de préférence, inférieure ou égale à 3*10¹⁵cm⁻³. Le caisson 14 s'étend jusqu'à une profondeur inférieure à 1µm et, de préférence, inférieure ou égale à 700nm.

Les zones 22 et 24 présentent ici, respectivement, des dopages de types p et n. Ces zones 22 et 24 s'étendent perpendiculairement à une direction normale au substrat sur une profondeur au plus égale à 110nm ou 100nm. Cette profondeur est ici définie selon la direction verticale, par rapport au plan s'étendant le long de l'interface entre la couche isolante 10 et le plan de masse 12. Un contact métallique est ici déposé directement sur chacune des zones 22 et 24, afin de permettre une connexion électrique de chacune de ces zones 22, 24 à un circuit électrique.

Avantageusement, les zones 22 et 24 présentent chacune une concentration de dopants au moins cinquante fois, ou soixante fois, ou cent fois supérieure à la concentration de dopants du caisson 14. Par exemple, les zones 22 et 24 présentent des concentrations de dopants avantageusement supérieures ou égales à 5*10¹⁸cm⁻³ et, de préférence, comprises entre 10¹⁹cm⁻³ et 10²¹cm⁻³ Ces concentrations de dopants sont par exemple sensiblement égales aux concentrations de dopants de la source ou du drain du transistor 8.

La figure 7 représente plus en détail le composant 6. Ce composant 6 est identique au composant 4, sauf que les types des dopages du transistor, du plan de masse du caisson et des zones semi-conductrices sont différents. Ainsi, le composant 6 comprend :
- un transistor 30 métal oxyde semi-conducteur (MOS) à effet de champ, de technologie FDSOI et de type opposé au transistor 8 ;
- la couche isolante 10, s'étendant également à l'aplomb du transistor 30 ;
- un plan de masse 32 semi-conducteur, formé à l'aplomb de la couche isolante 10 et présentant un dopage opposé au plan de masse 12 ;
- un caisson semi-conducteur 34, formé à l'aplomb du plan de masse 32 et présentant un dopage opposé au caisson 14 ;
- une tranchée d'isolation 36, pouvant présenter une profondeur et une composition identiques à la tranchée 16, et disposée de manière à séparer les composants 4 et 6.

Le transistor 30 est ici un transistor FDSOI de type n-MOS. Ce transistor 30 présente ici une longueur de grille supérieure ou égale à 20nm.

Le composant 6 comprend également une diode 40, identique à la diode 20, sauf qu'elle est ménagée sur un côté du transistor 30 et séparée de ce transistor 8 par une tranchée d'isolation 41, de profondeur, d'épaisseur et/ou de composition identiques à la tranchée 21. Cette diode 40 comprend des zones semi-conductrices 42 et 44 de dopages opposés, et séparés par une tranchée d'isolation 46 similaire à la tranchée 26. Cette diode 40 comprend également une troisième zone semi-conductrice (non représentée sur cette figure), similaire à la zone 28 et reliant les zones 42 et 44. Les zones 42 et 44 sont électriquement connectées, respectivement, à des électrodes F1 et F2 du transistor 30. Les zones 42 et 44 présentent, respectivement, des dopages de types n et p. Ici, la troisième zone semi-conductrice de ce composant 6 est formée par un prolongement du plan de masse 32 latéralement au-delà de la tranchée 41, puis selon la direction verticale jusqu'à la tranchée 46.

Dans cet exemple, les transistors 8 et 30 sont connectés entre eux de sorte à ce que le circuit 2 comporte un inverseur logique de type CMOS (« Complementary Metal Oxide Semiconductor » en langue anglaise). De façon connue, un tel inverseur logique présente une entrée IN, configurée pour recevoir un signal logique d'entrée et une sortie OUT, configurée pour retourner un signal logique correspondant à l'inverse logique du signal d'entrée. Un tel inverseur peut notamment être utilisé comme interface d'entrée/sortie d'un circuit intégré. A cet effet, dans ce circuit 2 :
- les grilles respectives des transistors 8 et 30 sont électriquement connectées entre elles et électriquement connectées à l'entrée IN,
- les drains respectifs des transistors 8 et 30 sont électriquement connectés entre eux et électriquement connectés à la sortie OUT, et
- les sources des transistors 8 et 30 sont, respectivement, électriquement polarisées à une tension d'alimentation VDD et à une masse GND du circuit 2 ;
- le substrat 18 est électriquement connecté à la masse GND.

Les diodes 20 et 40 sont ici utilisées pour former un dispositif de protection électrique des transistors 8 et 30 du circuit 2. Ce dispositif est configuré pour protéger les transistors 8 et 30 contre des décharges électrostatiques et pour évacuer ces décharges électrostatiques vers des rails d'alimentation électriques du circuit 2 (non représentés sur les dessins). Ici, ces rails d'alimentation sont électriquement reliés à la masse GND et à une source fournissant la tension d'alimentation VDD. De façon connue, le circuit 2 comporte une protection centrale permettant notamment d'évacuer des décharges électrostatiques survenant entre les rails d'alimentation VDD et de masse GND.

La figure 8 représente un premier exemple d'utilisation des diodes 20 et 40 pour protéger le circuit 2. Les diodes 20 et 40 sont connectées de façon à protéger plus spécifiquement l'entrée IN du circuit 2. A cet effet :
- les électrodes E1 et F1 correspondent, respectivement, aux grilles des transistors 8 et 30 ;
- les électrodes E2 et F2 correspondent, respectivement, aux sources des transistors 8 et 30 ;
- les plans de masse 12 et 32 sont électriquement connectés, respectivement, aux électrodes E2 et F2 ;
- les anodes des diodes 20 et 40 sont, respectivement, électriquement connectées aux électrodes E1 et F2 ;
- les cathodes des diodes 20 et 40 sont, respectivement, électriquement connectées aux électrodes E2 et F1.

Un exemple de fonctionnement de ce dispositif de protection va maintenant être brièvement décrit. Par exemple, dans un fonctionnement normal, l'entrée IN du circuit est portée à un potentiel électrique sensiblement égal soit à la masse GND, soit à la tension VDD. Les diodes 20 et 40 sont donc dans un état ne permettant pas un passage de courant électrique.

En présence d'une décharge électrostatique importante sur l'entrée IN et positive par rapport à la masse GND, le potentiel électrique de cette entrée IN peut être augmenté jusqu'à une valeur supérieure à la tension VDD. Dans ce cas, du fait de la différence de potentiel électrique présente à ses bornes, la diode 20 est dans un état laissant passer un courant électrique. Un chemin d'évacuation local est ainsi formé, avant de bénéficier de la protection centrale. La protection centrale permet ensuite au courant de s'évacuer de VDD vers GND. Pour une décharge électrostatique induisant une tension inférieure à la tension GND sur l'entrée IN, la diode 40 est dans un état passant. Le courant électrique correspondant à la décharge électrostatique peut ainsi être évacué par les diodes 20 ou 40 en court-circuitant les transistors 8 et 30.

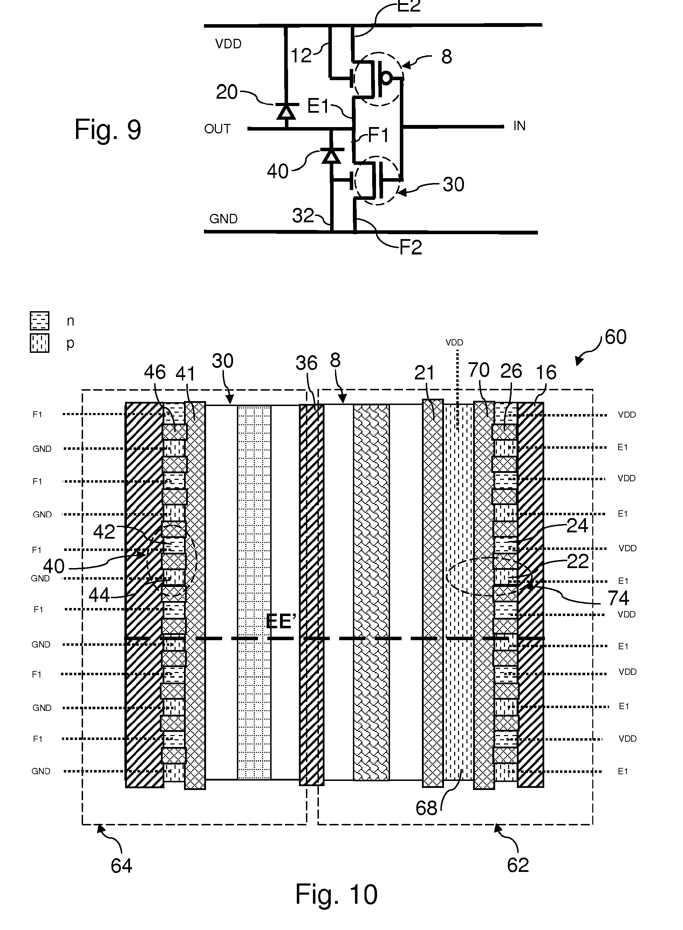

La figure 9 représente un autre exemple d'utilisation des diodes 20 et 40 pour protéger le circuit 2. Les diodes 20 et 40 sont ici connectées de façon à protéger plus spécifiquement la sortie OUT du circuit 2. A cet effet :
- les électrodes E1 et F1 correspondent, respectivement, aux drains des transistors 8 et 30 ;
- les électrodes E2 et F2 correspondent, respectivement, aux sources des transistors 8 et 30 ;
- les plans de masse 12 et 32 sont électriquement connectés, respectivement, aux électrodes E2 et F2 ;
- les anodes des diodes 20 et 40 sont, respectivement, électriquement connectées aux électrodes E1 et F2 ;
- les cathodes des diodes 20 et 40 sont, respectivement, électriquement connectées aux électrodes E2 et F1.

En présence d'une décharge électrostatique importante sur la sortie OUT et positive par rapport à la masse GND, le potentiel électrique de cette sortie OUT peut être abaissé jusqu'à une valeur inférieure à la tension GND. Dans ce cas, du fait de la différence de potentiel électrique présente à ses bornes, la diode 40 est dans un état laissant passer un courant électrique. Pour une décharge électrostatique induisant une tension supérieure à la tension VDD sur la sortie OUT, la diode 20 est dans un état passant. Un chemin d'évacuation local est ainsi formé, avant de bénéficier de la protection centrale. La protection centrale permet ensuite au courant de s'évacuer du rail VDD vers le rail GND. Le courant électrique correspondant à la décharge électrostatique peut ainsi être évacué par les diodes 20 ou 40 en court-circuitant les transistors 8 et 30.

La figure 10 représente un circuit intégré 60, apte à remplacer le circuit 2 et comportant un dispositif de protection contre des décharges électrostatiques. Ce circuit 60 comprend des composants 62 et 64. Ce circuit 60 est sensiblement identique au circuit 2, sauf que le dispositif de protection est distinct de celui du circuit 2.

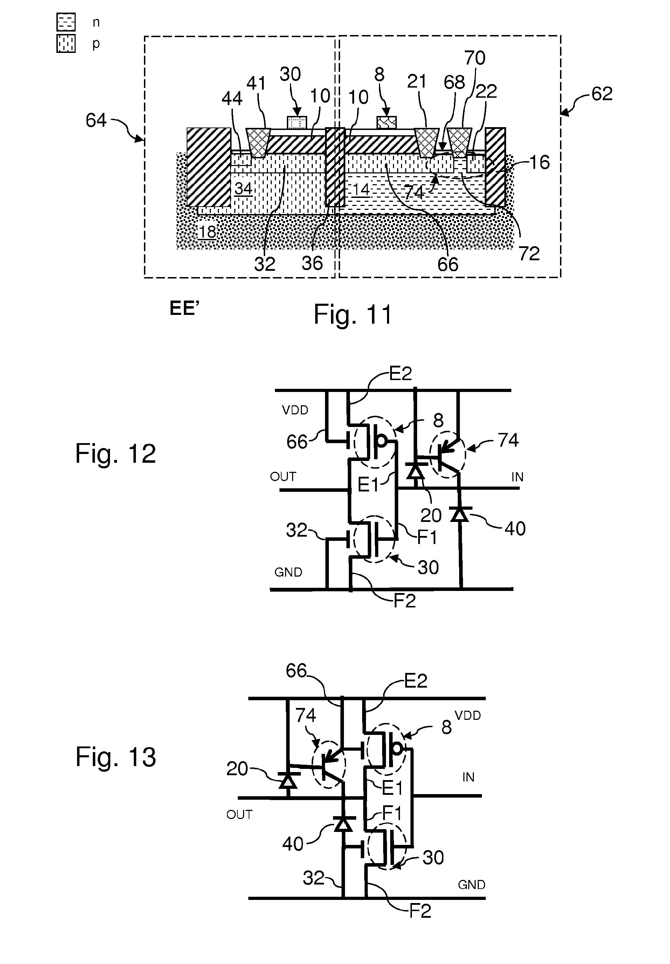

La figure 11 représente plus en détail ces composants 62 et 64. Le composant 62 est identique au composant 4, sauf que :
- le plan de masse 12 est remplacé par un plan de masse 66 présentant un dopage de type opposé, le dopage du plan de masse 66 étant alors choisi du même type que celui de la zone 22 ;
- le composant 62 comporte en outre :
   - un contact électrique 68, pour appliquer au plan de masse 66 l'une ou l'autre de la tension VDD ou de la masse GND ;
   - une tranchée d'isolation 70, de profondeur, d'épaisseur et/ou de composition identiques à la tranchée 26 et séparant le plan de masse 66 des zones 22 et 24 ;
   - une zone semi-conductrice 72, formant une jonction entre la zone 22 et le plan de masse 66 de façon à former un transistor bipolaire 74 entre le plan de masse 66 et la zone 22.
- la zone 28 est formée par un prolongement latéral du caisson 14 par rapport à la tranchée 70, s'étendant verticalement jusqu'à la tranchée 26 ;

Le composant 64 est ici identique au composant 6.

Dans cet exemple, la zone 72 est formée par un prolongement du caisson 14 selon la direction verticale. Cette zone 72 présente un dopage de type n, de sorte que le transistor 74 soit un transistor bipolaire de type PNP.

Les diodes 20 et 40 et le transistor 74 sont ici utilisés pour former un dispositif de protection électrique des transistors 8 et 30 du circuit 60 distinct de celui du circuit 2. L'utilisation du transistor 74 dans ce dispositif de protection permet d'améliorer l'évacuation de courant électrique en cas de décharge électrostatique. En particulier, le transistor 74 présente un gain en courant, qui permet d'obtenir une évacuation du courant plus rapide. Le transistor 74 permet également de proposer un chemin additionnel de protection local lors de surtensions négatives sur la borne IN par rapport à la tension VDD (ou surtension positive sur VDD par rapport à la borne IN). En effet, dans le cadre d'une protection centrale classique, la surtension est écrêtée par la diode 40 et la protection d'alimentation, obligeant le courant à circuler dans les rails d'alimentation. La chute de tension liée a la résistance non nulle de ces rails limite la performance globale de la protection. Le transistor 74 permet un chemin local direct entre VDD et IN utilisant le phénomène de courant de retournement du transistor (« snapback current » en langue anglaise). Lors d'une surtension positive sur VDD, la jonction entre la zone 24 et 72 est en inverse, le courant de fuite ou d'ionisation par impact permet alors d'augmenter localement le potentiel du caisson 72 enclenchant le bipolaire entre VDD et IN.

La figure 12 représente un premier exemple de dispositif de protection du circuit 60. Les diodes 20 et 40 et le transistor 74 sont connectés de façon à protéger plus spécifiquement l'entrée IN du circuit 60. A cet effet :
- les électrodes E1 et F1 correspondent, respectivement, aux grilles des transistors 8 et 30 ;
- les électrodes E2 et F2 correspondent, respectivement, aux sources des transistors 8 et 30 ;
- les plans de masse 66 et 32 sont électriquement connectés, respectivement, aux électrodes E2 et F2 ;
- les anodes des diodes 20 et 40 sont, respectivement, électriquement connectées aux électrodes E1 et F2 ;
- les cathodes des diodes 20 et 40 sont, respectivement, électriquement connectées aux électrodes E2 et F1 ;
- des base, collecteur et émetteur du transistor 74 sont respectivement connectés électriquement à la cathode de la diode 20, aux électrodes E1 et E2.

Lorsque la diode 20 entre dans un état passant, le transistor 74 entre à son tour dans un état passant, du fait du courant appliqué sur sa base. Ainsi, la décharge peut être évacuée en limitant fortement l'apparition de surintensité. Lorsque la diode 20 est polarisée en inverse, le courant de fuite circulant au travers de cette diode 20 enclenche le transistor 74 entrainant le phénomène de courant de retournement, ce qui permet d'évacuer la décharge en limitant fortement la surintensité.

La figure 13 représente un autre exemple du circuit 60. Les diodes 20 et 40 et le transistor 74 sont connectés de façon à protéger plus spécifiquement la sortie OUT du circuit 60. Ce circuit est identique à celui décrit à la figure 12, sauf que les électrodes E1 et F1 correspondent, respectivement, aux drains des transistors 8 et 30.

Lorsque la diode 20 entre dans un état passant, le transistor 74 entre à son tour dans un état passant, du fait du courant appliqué sur sa base. Ainsi, la décharge peut être évacuée en limitant fortement l'apparition de surintensité. Lorsque la diode 20 est polarisée en inverse, le courant de fuite circulant au travers de cette diode 20 enclenche le transistor 74, entrainant à son tour le phénomène de courant de retournement.

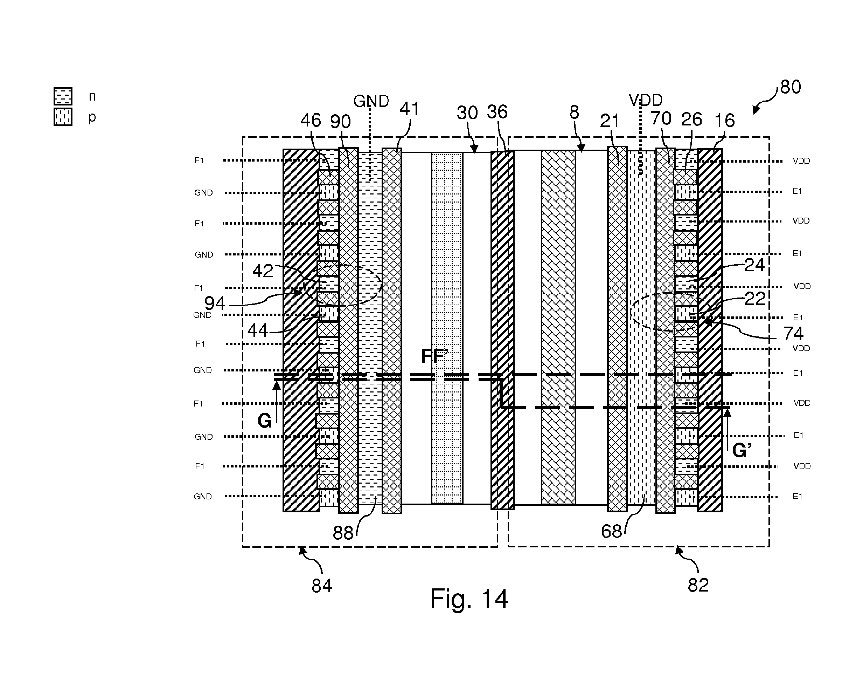

La figure 14 représente un circuit intégré 80, apte à remplacer les circuits 60 ou 2 et comportant un dispositif de protection contre des décharges électrostatiques. Ce circuit 80 comprend des composants 82 et 84. Ce circuit 80 est sensiblement identique au circuit 60, sauf que le dispositif de protection est distinct de celui du circuit 60.

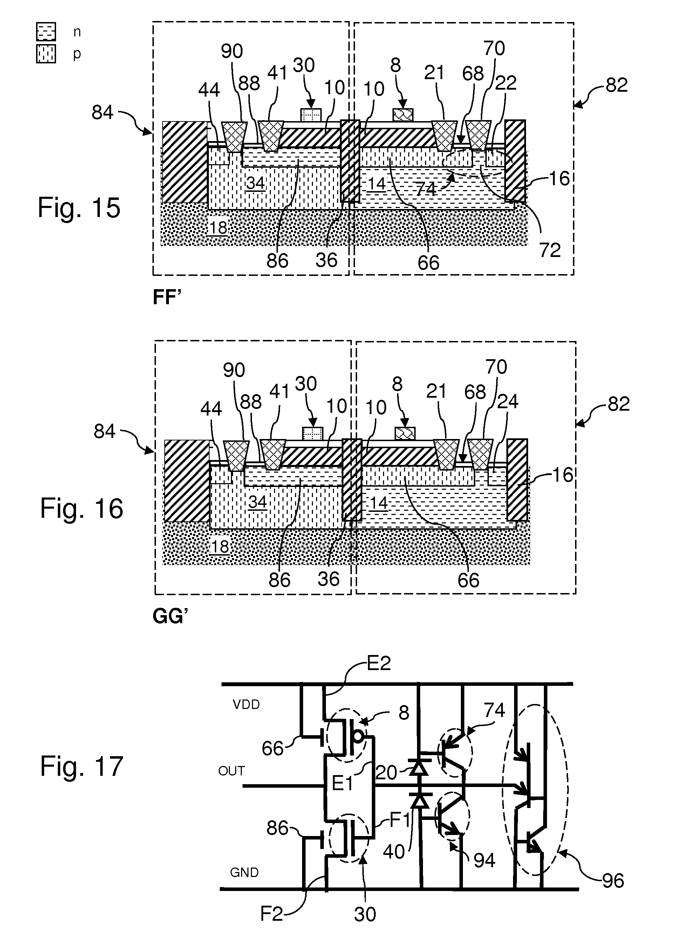

Les figures 15 et 16 représentent plus en détail ces composants 82 et 84.

Le composant 82 est ici identique au composant 62.

Le composant 84 est sensiblement identique au composant 64, sauf que :
- le plan de masse 32 est remplacé par un plan de masse 86 présentant un dopage de type opposé, le dopage du plan de masse 86 étant alors choisi du même type que celui de la zone 42 ;
- le composant 84 comporte en outre :
   - un contact électrique 88, pour appliquer au plan de masse 86 l'une ou l'autre de la tension VDD ou de la masse GND ;
   - une tranchée d'isolation 90, de profondeur, d'épaisseur et/ou de composition identiques à la tranchée 26 et séparant le plan de masse 86 des zones 42 et 44 ;
   - une zone semi-conductrice formant une jonction entre la zone 42 et le plan de masse 86 de façon à former un transistor bipolaire 94 (non visible sur les figures 15 et 16) entre le plan de masse 86 et la zone 42.
- la zone semi-conductrice du composant 84 est formée par un prolongement latéral du caisson 34 au-delà de la tranchée 90, s'étendant verticalement jusqu'à la tranchée 46 ;

Le circuit 80 comporte en outre un thyristor 96, formé par les zones 22, 66, les caissons 14 et 34 et le plan de masse 86.

Dans cet exemple, le transistor 94 est de type NPN.

Les diodes 20 et 40, les transistors 74 et 94 et le thyristor 96 sont ici utilisés pour former un dispositif de protection électrique des transistors 8 et 30 du circuit 80 qui est distinct de celui des circuits 2 et 60. L'utilisation du thyristor 96 dans ce dispositif de protection permet d'améliorer l'évacuation du courant électrique provenant d'une décharge électrostatique.

La figure 17 représente un exemple d'utilisation du dispositif de protection du circuit 80, ici connecté de façon à protéger plus spécifiquement l'entrée IN du circuit 80. A cet effet :
- les électrodes E1 et F1 correspondent, respectivement, aux grilles des transistors 8 et 30 ;
- les plans de masse 66 et 86 sont électriquement connectés, respectivement, aux électrodes E2 et F2 ;
- les anodes des diodes 20 et 40 sont, respectivement, électriquement connectées aux électrodes E1 et F2 ;
- les cathodes des diodes 20 et 40 sont, respectivement, électriquement connectées aux électrodes E2 et F1 ;
- la base du transistor 74 est électriquement connectée à la cathode de la diode 20, le collecteur du transistor 74 à l'électrode E1 et l'émetteur du transistor 74 à l'électrode E2 ;
- la base du transistor 94 est électriquement connectée à l'anode de la diode 40, le collecteur à l'électrode F1 et l'émetteur à l'électrode E2 ;
- l'anode du thyristor 96 est électriquement connectée à l'électrode F2, la cathode et la gâchette du thyristor 96 sont électriquement connectées à l'électrode E2.

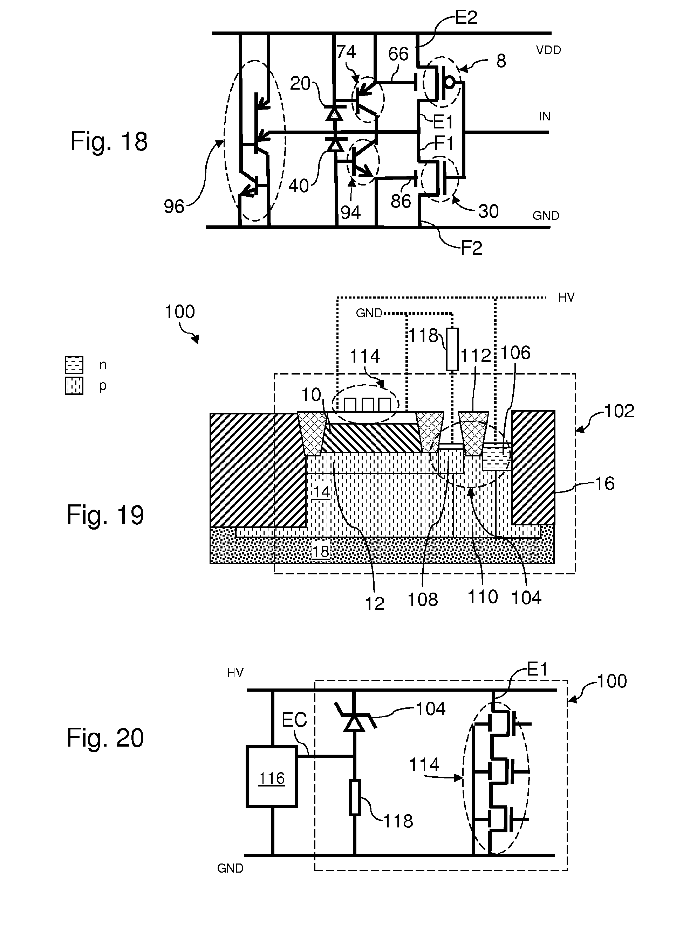

La figure 18 représente un autre exemple du dispositif de protection du circuit 80, ici connecté de façon à protéger plus spécifiquement la sortie OUT du circuit 80. Ce circuit est identique à celui décrit à la figure 17, sauf que les électrodes E1 et F1 correspondent, respectivement, aux drains des transistors 8 et 30.

La figure 19 représente un circuit intégré 100, fabriqué sur SOI et comportant un composant 102. Ce composant 102 est identique au composant 4, sauf que la diode 20 est remplacée par une diode Zener 104. A cet effet, la diode 104 comprend :
- des zones semi-conductrices 106, 108 et 110, respectivement, identiques aux zones 22, 24 et 28, sauf que :
   - la zone 110 présente un dopage de type p ;
   - la zone 106 présente un dopage de type n, avec une concentration de dopants supérieure ou égale à 5*10¹⁷cm⁻³, à 10¹⁸cm⁻³ ou, de préférence, à 1*10¹⁹ cm⁻³.
- une tranchée d'isolation 112, de profondeur, d'épaisseur et/ou de composition identiques à la tranchée 26, séparant les zones 106 et 108.

Avantageusement, la diode 104 présente une tension de claquage Zener, en valeur absolue, supérieure à 2 Volts et inférieure à 20 Volts, 15 Volts ou 10 Volts. Cette tension de claquage est ajustable lors d'étapes de conception et/ou de fabrication du circuit 100, notamment en ajustant la dimension latérale de la tranchée d'isolation 112 ou de la concentration en dopants des zones semi-conductrices formant la diode 104.

Avantageusement lorsque cette dimension latérale est inférieure à 250 nm ou à 200nm, la tension de claquage de la diode 104 est gouvernée essentiellement par la dimension latérale et non plus essentiellement par ladite concentration en dopants.

Ici, le composant 102 comprend, à la place du transistor 8, une pluralité de transistors MOS de type n-FET identiques au transistor 8, cette pluralité incluant au moins un premier transistor 103. Ces transistors sont électriquement connectés en cascode, formant un dispositif 114. Ce dispositif 114 s'étend électriquement entre une masse électrique GND du circuit et une première électrode E1. Cette électrode E1 est ici portée à un potentiel HV.

Avantageusement, la zone 110 présente une concentration de dopants inférieure à 10¹⁷cm⁻³ ou inférieure à 5*10¹⁶cm⁻³.

Dans cet exemple, la diode 104 est utilisée, en cas d'apparition d'une décharge électrostatique, pour déclencher un dispositif de protection 116. Ce dispositif 116 est configuré pour court-circuiter le dispositif 114 et le protéger contre des décharges électrostatiques.

A cet effet, comme illustré à la figure 20, dans ce circuit :
- la zone 108 est électriquement connectée à une électrode de commande EC du dispositif 116 d'une part et au plan de masse 12, par l'intermédiaire d'un dipôle résistif 118 d'autre part,
- le plan de masse 12 est électriquement connecté à la masse GND, et
- la zone 106 est électriquement connectée à l'électrode E1.

Un exemple de fonctionnement de ce dispositif de protection va maintenant être brièvement décrit. Par exemple, en fonctionnement normal, la différence de potentiel entre HV et GND reste inférieure à la tension de claquage Zener de la diode 104. La diode 104 est alors dans un état ne permettant pas de circulation de courant électrique au travers de la branche du circuit comprenant la diode 104.

En présence d'une décharge électrostatique sur l'électrode E1, cette différence de potentiel peut augmenter sensiblement, au point de dépasser la tension de claquage Zener de la diode 104. Dans ce cas, la diode 104 entre dans un état permettant la circulation de courant vers l'électrode de commande EC du dispositif 116, ce qui permet de protéger le dispositif 114. L'électrode de commande du dispositif 116 peut être soit la gâchette d'un thyristor, la gâchette d'un triac, la base d'un transistor bipolaire, ou la grille d'un transistor à effet de champ.

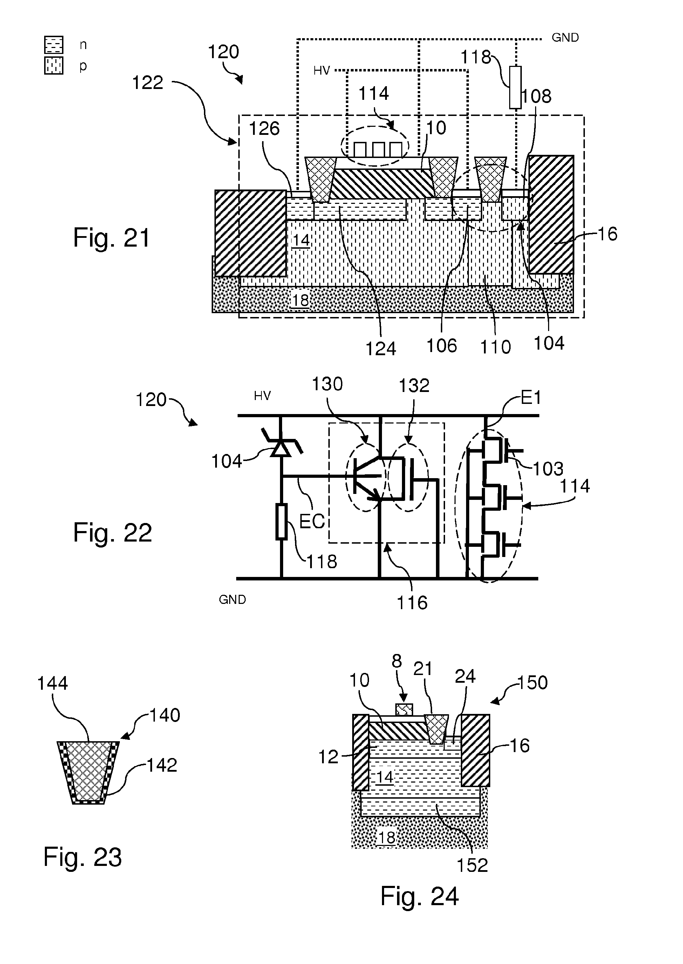

Les figures 21 et 22 représentent un circuit 120 comportant un exemple d'un dispositif de protection 116. Ce circuit 120 comprend un composant 122 identique au composant 102, sauf que :
- le plan de masse 12 est remplacé par un plan de masse 124 présentant un dopage de type n,
- le caisson 14 présente un dopage de type p,
- le composant comprend une zone semi-conductrice 126, présentant un dopage du même type que la zone 106, cette zone 126 formant un contact électrique pour appliquer une polarisation électrique sur le plan de masse 124,
- la zone 126 est électriquement connectée à la zone 108 et à la masse GND de manière à ce que les zones 104, 106 et 126, forment un transistor bipolaire 130, ici de type NPN. Le dispositif 116 comprend également un transistor MOSFET 132 présentant un dopage de canal de type n.

La figure 23 illustre une tranchée d'isolation 140 apte à remplacer la tranchée 26. Cette tranchée 140 est similaire à la tranchée 26, sauf qu'elle comporte sur ses parois latérales un revêtement 142 d'un second matériau électriquement isolant. Ce second matériau est différent du matériau électriquement isolant 144 formant la tranchée 26. Ce second revêtement est ici une couche de nitrure de silicium Si₃N₄. Le revêtement 142 présente, par exemple, une épaisseur typiquement comprise entre 2nm et 10nm.

Ainsi, le risque d'endommagement de la tranchée d'isolation pendant des étapes du procédé de fabrication du circuit est réduit.

La figure 24 représente un composant 150, apte à remplacer le composant 4. Ce composant 150 est sensiblement identique au composant 4 sauf qu'il comporte en outre un caisson profondément enterré 152. Ce caisson 152 est formé sous le caisson 14 et à l'aplomb de ce caisson 14. Ce caisson 152 présente un dopage de type n. Ici, ce caisson 152 présente une concentration de dopants comprise entre 10¹⁶cm⁻³ et 10¹⁸cm⁻³.

De nombreux autres modes de réalisation sont possibles.

En variante, les types de dopages des transistors, des plans de masse, et des caissons respectifs des composants 4 et 6 peuvent être intervertis. Il en va de même pour les composants 62 et 64, et pour les composants 82 et 84.

En variante, dans le circuit 2, le composant 6 peut être omis. Dans ce cas, le dispositif de protection est différent de celui décrit.

Les circuits 2, 60 et 80 peuvent comporter un nombre de transistors différent et/ou de nature différents de ceux décrits. Ces transistors peuvent être connectés de façon à former un circuit différent de l'inverseur logique CMOS décrit. Les modes de réalisation décrits pour la zone 28 du composant 4 peuvent s'appliquer à la troisième zone du composant 6.

En variante, les circuits 2, 60, 80, 100 et 120 comprennent un caisson profondément enterré. Ce caisson profondément enterré, présente par exemple un dopage de type n pour un substrat 18 de type p, et est formé sous et à l'aplomb des caissons 14 et 34. On peut bien entendu également envisager un caisson profondément enterré de type p pour un substrat 18 de type n.

En variante, une reprise d'épitaxie peut être effectuée sur les zones 20, 22, 24, 42, 44, pour éviter la différence d'altitude avec les transistors 8 et 30.

En variante, les transistors 74 et 94 du circuit 80 sont connectés de façon à être dans des états actifs lorsque la diode 20 est passante. Dans ce cas :
- le collecteur et l'émetteur du transistor 74 sont électriquement connectés, respectivement, aux électrodes E2 et E1 ;
- le collecteur et l'émetteur du transistor 94 sont électriquement connectés, respectivement, aux électrodes F2 et F1.

Les gammes de tension de seuil des transistors 8 et 30 peuvent être différentes.

Les longueurs de grille des transistors 8 et 30 peuvent être différentes de 20nm. Ces longueurs de grille peuvent, par exemple, être supérieures à 20nm, ou inférieures à 20nm.

## Revendications

1. Circuit intégré (2, 100, 120) comprenant :
- un premier composant (4, 5, 102, 122) comportant :
• un premier transistor (8, 103) MOS de technologie FDSOI ;
• une couche isolante enterrée (10) de type UTBOX, disposée sous le premier transistor ;
• un premier plan de masse (12, 124) semi-conducteur, disposé sous la couche isolante ;
• un premier caisson (14) semi-conducteur, disposé sous le premier plan de masse ;
• une première tranchée d'isolation (16), ménagée à la périphérie du transistor et s'étendant au travers de la couche isolante enterrée jusque dans le premier caisson ;
- un substrat semi-conducteur (18), situé sous le premier caisson ;
le premier composant comportant en outre une diode p-n (20, 104), ménagée sur un côté du premier transistor et comportant des première (22, 106) et seconde (24, 108) zones semi-conductrices de dopages opposés, la première zone semi-conductrice étant adaptée à être électriquement connectée à une première électrode (E1) du premier transistor ;
- ces première et seconde zones semi-conductrices étant coplanaires au premier plan de masse,
le premier composant comprenant en outre :
- une seconde tranchée d'isolation (26, 112) pour séparer ces première et seconde zones semi-conductrices, cette seconde tranchée d'isolation s'étendant au travers de la couche isolante enterrée, jusque dans le premier plan de masse et jusqu'à une profondeur strictement inférieure à l'interface entre le premier plan de masse et le premier caisson, et
- une troisième zone (28, 110) semi-conductrice sous la seconde tranchée, formant une première jonction entre les première et seconde zones.

2. Circuit selon la revendication 1, dans lequel :
- la seconde zone semi-conductrice est adaptée à être électriquement connectée au premier plan de masse et à une seconde électrode (E2) du premier transistor, et
- la troisième zone semi-conductrice est un prolongement du premier plan de masse ou du premier caisson.

3. Circuit selon la revendication 2, dans lequel une première polarisation à l'une ou l'autre d'une masse électrique (GND) ou d'une tension d'alimentation (VDD) du circuit est adaptée à être appliquée sur la seconde électrode.

4. Circuit (60) selon la revendication 3, dans lequel :
- le premier plan de masse (66) présente un dopage du même type que la première zone semi-conductrice,
- la troisième zone semi-conductrice est un prolongement du premier caisson,
- le premier composant (62) comprend en outre :
• un premier contact électrique (68) pour appliquer ladite polarisation électrique directement sur le premier plan de masse,
• une troisième tranchée d'isolation (70), séparant le premier plan de masse des première et seconde zones semi-conductrices, cette troisième tranchée d'isolation s'étendant au travers de la couche isolante enterrée, jusque dans le premier plan de masse et jusqu'à une profondeur strictement inférieure à l'interface entre le premier plan de masse et le premier caisson,
• une quatrième zone semi-conductrice (72), formant une seconde jonction entre la première zone et le premier plan de masse, de façon à former un transistor bipolaire (74) entre le plan de masse et la première zone.

5. Circuit (80) selon la revendication 4, comportant un second composant (84), ce second composant incluant :
- un second transistor MOS (30) de technologie FDSOI, de type opposé à celui du premier transistor,
- un second plan de masse (86) semi-conducteur, disposé sous la couche isolante et présentant un dopage opposé au dopage du premier plan de masse,
- un second caisson (34) semi-conducteur, formé à l'aplomb du second plan de masse et présentant un dopage opposé au dopage du premier caisson,
- un second contact électrique (88), pour appliquer directement sur le second plan de masse l'autre polarisation électrique parmi ladite masse électrique ou ladite tension d'alimentation,
- une quatrième tranchée d'isolation (90), disposée de manière à séparer les premier et second composants, cette quatrième tranchée d'isolation étant ménagée à la périphérie du second transistor et s'étendant au travers de la couche isolante enterrée jusque dans les premier ou second caissons.

6. Circuit (100, 120) selon la revendication 1, dans lequel :
- la troisième zone (110) semi-conductrice présente un dopage de type p,
- la première zone (106) semi-conductrice présente un dopage de type n, avec une concentration de dopants supérieure ou égale à 5*10¹⁸cm⁻³,
- la seconde zone (108) semi-conductrice est adaptée à être électriquement connectée au premier plan de masse (12, 124), ce premier plan de masse étant adapté à être électriquement connecté à une masse électrique (GND) du circuit,
- la seconde zone semi-conductrice est en outre adaptée à être électriquement connectée à une électrode de commande (EC) d'un dispositif de protection (116) configuré pour court-circuiter le premier transistor et le protéger contre des décharges électrostatiques.

7. Circuit selon la revendication 6, dans lequel la troisième zone (110) semi-conductrice présente une concentration de dopants inférieure à 5*10¹⁶cm⁻³.

8. Circuit selon les revendications 6 ou 7, dans lequel :
- la diode p-n (104) présente une tension de claquage Zener, en valeur absolue, supérieure à 2 Volts et inférieure à 10 Volts ;
- le premier transistor (103) est incorporé dans un montage (114) en cascode, ce montage s'étendant électriquement entre la masse du circuit et la première électrode (E1).

9. Circuit (120) selon l'une quelconque des revendications 6 à 8, comprenant le dispositif de protection et dans lequel :
- le plan de masse (124) présente un dopage de type n,
- le caisson (14) présente un dopage de type p,
- le premier composant (122) comprend une cinquième zone (126) semi-conductrice, présentant un dopage du même type que la première zone, cette cinquième zone formant un contact électrique pour appliquer une polarisation électrique sur le plan de masse,
- la cinquième zone est électriquement connectée à la seconde zone et à la masse électrique du circuit, de manière à former un transistor bipolaire (130) formant le dispositif de protection (116).

10. Circuit selon l'une quelconque des revendications précédentes, dans lequel la seconde zone (24) semi-conductrice présente un dopage du même type que le premier caisson semi-conducteur, avec une concentration de dopants supérieure ou égale à 10¹⁹cm⁻³ et la première zone semi-conductrice présente un dopage de type opposé, avec une concentration de dopants supérieure ou égale à 10¹⁹cm⁻³.

11. Circuit selon l'une quelconque des revendications précédentes, dans lequel les première (22) et seconde (24) zones semi-conductrices présentent une concentration de dopants au moins cinquante fois supérieure à la concentration de dopants du premier caisson (14) semi-conducteur.

12. Circuit selon l'une quelconque des revendications précédentes, dans lequel la plus petite distance séparant les première (22) et seconde (24) zones est inférieure ou égale à 100nm.

13. Circuit selon l'une quelconque des revendications précédentes, dans lequel la seconde tranchée d'isolation (26) s'étend jusque dans le premier plan de masse, jusqu'à une profondeur inférieure ou égale à 80nm en-dessous de l'interface séparant la couche d'oxyde enterrée du premier plan de masse.

14. Circuit selon l'une quelconque des revendications précédentes, dans lequel la seconde tranchée d'isolation comprend un revêtement isolant (142) incluant du nitrure de silicium Si₃N₄, ce revêtement recouvrant des parois latérales de ladite seconde tranchée.

15. Circuit selon l'une quelconque des revendications précédentes, dans lequel le premier composant comprend en outre un caisson profondément enterré (152) présentant un dopage de type n, ce caisson profondément enterré étant formé sous et à l'aplomb du premier caisson (14).
